# FASCICULE DE BREVET EUROPEEN

(11) **EP 1 922 789 B1**
(45) Date de publication et mention de la délivrance du brevet: **15.07.2009**
(21) Numéro de dépôt: 06793121.2
(22) Date de dépôt: 31.08.2006
(51) Int. Cl.: H01S 5/183, H01S 5/327, H01S 5/04

(54) **DISPOSITIF D'EMISSION DE LUMIERE AVEC COUCHE FILTRANTE**
LICHT EMITTIERENDE ANORDNUNG MIT FILTERSCHICHT
LIGHT EMITTING DEVICE WITH FILTERING LAYER

(30) Priorité: 05.09.2005 FR 0552680
(43) Date de publication de la demande: 21.05.2008
(73) Titulaire: COMMISSARIAT A L'ENERGIE ATOMIQUE, 75015 Paris (FR)
(72) Inventeur: BALLET, Philippe, F-38250 Lans En Vercors (FR)
(74) Mandataire: Poulin, Gérard
(86) Numéro de dépôt international: PCT/EP2006/065886
(87) Numéro de publication internationale: WO 2007/028765

(56) Documents cités:
- FR-A- 2 833 757
- FR-A- 2 833 758
- HADJI E ET AL: "3.3- MUM MICROCAVITY LIGHT EMITTER FOR GAS DETECTION" OPTICS LETTERS, OSA, OPTICAL SOCIETY OF AMERICA, WASHINGTON, DC, US, vol. 25, no. 10, 15 juin 2000 (2000-06-15), pages 725-727, XP000951922 ISSN: 0146-9592

## Description

### DOMAINE TECHNIQUE ET ART ANTÉRIEUR

L'invention concerne le domaine des dispositifs d'émission de lumière tels que présentés par exemple dans les documents FR-2 833 757 et FR-2 833 758.

Dans ces documents sont décrits des procédés de fabrication de dispositifs d'émission de lumière pour lesquels des couches d'arrêt sont insérées dans les structures.

La figure 1 représente un tel empilement décrit dans ce document antérieur, qui comporte, entre deux miroirs de Bragg 2, 4, des couches barrière 6, 8, une couche de puits 10 et une couche d'arrêt 12.

La couche d'arrêt 12 est en CdHgTe, avec une composition d'alliage égale à celle du puits 10 émetteur de photons. L'avantage d'un tel dispositif est que la couche d'arrêt 12 n'induit plus de perte optique et peut même participer à l'émission de lumière. En pratique, la participation de cette couche à l'émission de lumière n'est pas optimale car le maximum du champ électrique, c'est à dire le lieu de couplage maximal entre les photons et la microcavité, est situé au niveau de la couche 10 de puits.

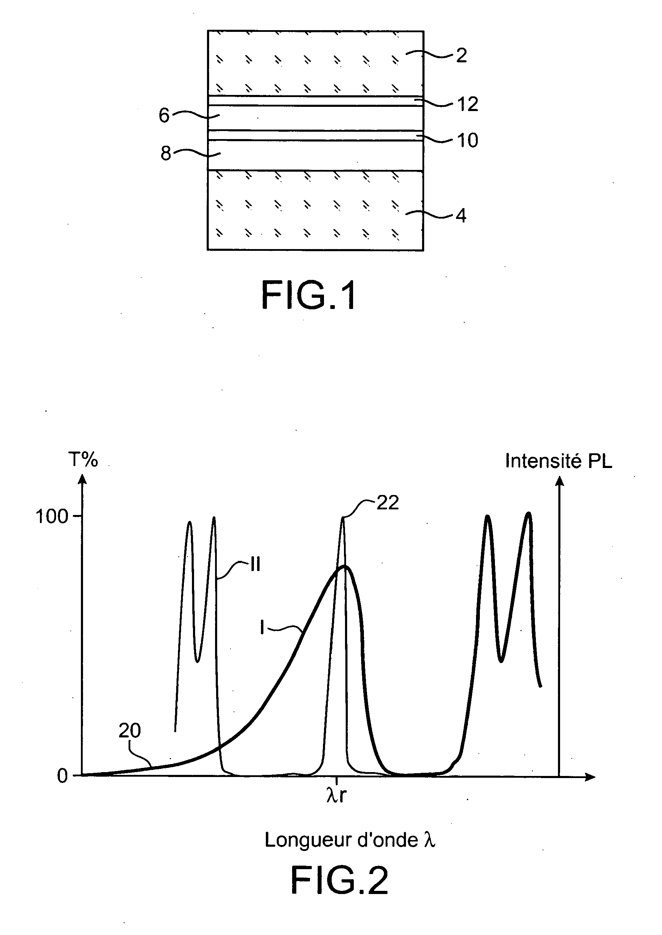

Cette microcavité de la figure 1 produit un rayonnement non monochromatique mais de largeur spectrale faible grâce au couplage avec la microcavité. Ce rayonnement est par exemple utilisé pour analyser la présence de certains gaz. Pour cela, la composition de la couche de puits est choisie pour obtenir un recouvrement spectral optimal entre le rayonnement émis et le spectre d'absorption du gaz considéré.

Les microcavités de ce type ont un défaut, qui est d'offrir une sélectivité spectrale non garantie. La largeur spectrale du spectre de photoluminescence est trop importante pour permettre une sélectivité complète via le couplage à la microcavité.

La figure 2 montre un spectre (courbe I) de photoluminescence typique de ces structures connues. Ce spectre présente une queue 20, du coté des hautes énergies, qui est intrinsèque à l'émission de CdHgTe à température ambiante. Superposé à ce spectre est également représentée une courbe II, ou spectre de transmission typique d'un couple de miroirs de Bragg (résonateur Fabry-Perrot) tels que ceux qui sont rajoutés à l'empilement CdHgTe pour former le dispositif émetteur final. La bande de réflectivité des miroirs (%T=0) a une largeur finie et présente, à la longueur d'onde λᵣ de résonance, un pic de transmission 22. La largeur finie de la bande de réflectivité fait que celle-ci ne couvre pas la queue haute énergie 20 du spectre de photoluminescence.

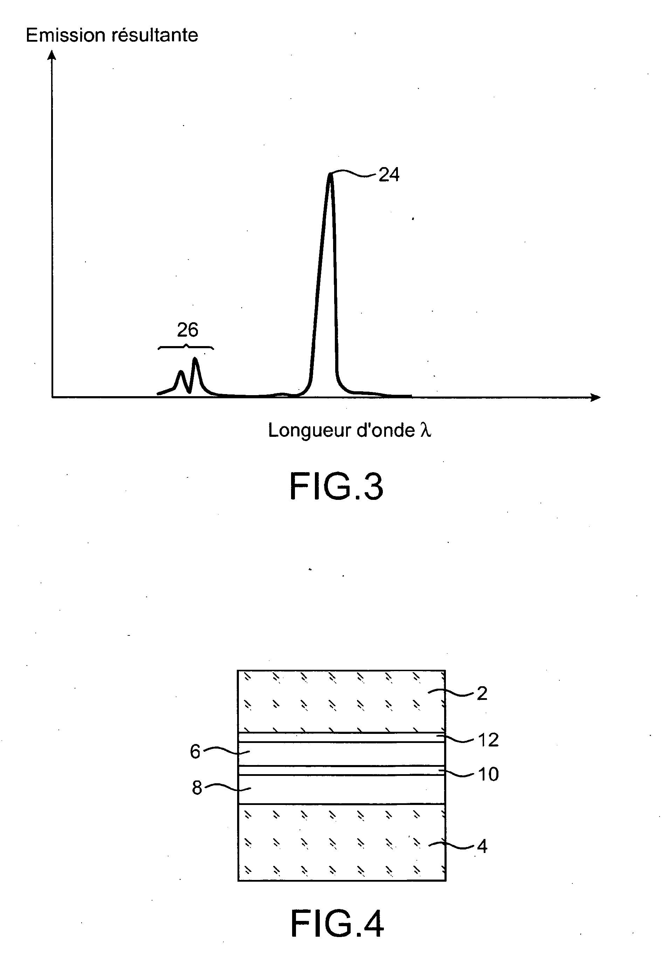

L'émission finale du dispositif émetteur est la résultante du filtrage par les miroirs de l'émission optique (photoluminescence). Elle est visible sur la figure 3. On voit bien l'affinement de la raie principale d'émission 24 (principal avantage de la microcavité) mais on voit aussi que la cavité laisse passer du rayonnement 26 parasite du côté des hautes énergies.

La présence de ce rayonnement parasite 26 diminue drastiquement la sélectivité spectrale d'un tel dispositif. En effet, même si l'intensité parasite est très inférieure à celle du pic principal, la première peut cependant (c'est fréquemment le cas) coïncider spectralement avec les raies d'absorption d'un composé présent en beaucoup plus grande proportion que le gaz à analyser. Cela peut-être particulièrement gênant si l'émission parasite correspond au domaine d'absorption des molécules d'eau.

Le spectre d'émission de la couche active de l'émetteur est recentré par la présence de la cavité résonante. Celle-ci laisse passer d'autres longueurs d'onde en dehors de sa bande de réflectivité, en particulier des longueurs d'onde plus courtes. La superposition des deux spectres constitue le spectre d'émission de l'émetteur : il apparaît alors des longueurs d'onde parasites dont la présence est préjudiciable à la précision du dispositif.

### EXPOSÉ DE L'INVENTION

Selon l'invention, afin de filtrer ces longueurs d'onde gênantes, on met en oeuvre, en tant que couche filtrante, la couche d'arrêt de gravure déjà présente dans l'empilement. Cette couche joue donc deux rôles : celui de couche d'arrêt et de couche de filtrage.

En tant que couche d'arrêt, elle est chimiquement différente du substrat à éliminer ; de plus elle a une composition qui permet de couper les longueurs d'onde indésirables.

Pour cette couche filtrante, on choisit de préférence un matériau voisin de celui utilisé dans la couche active, ce qui facilite le procédé de fabrication.

Ainsi, pour une couche en CdHgTe, sa composition est choisie de manière à absorber le rayonnement parasite.

L'invention concerne donc un dispositif d'émission de lumière comportant, entre un miroir d'entrée et un miroir de sortie formant une cavité, celle-ci présentant une bande de réflectivité, un empilement comportant lui-même une couche d'arrêt de gravure et une couche active **caractérisé en ce que** la couche d'arrêt est apte à filtrer au moins les longueurs d'onde inférieures à la limite inférieure de la bande de réflectivité

la couche active étant en CdₓHg₁₋ₓTe, et la couche d'arrêt en Cd_{y}Hg_{1-y}Te, avec x < y.

Si la couche d'arrêt est en Cd_{y}Hg_{1-y}Te, la cavité peut comporter deux couches barrières de composition Cd_{z}Hg_{1-z}Te, avec y < z.

La couche active est de préférence en un matériau apte à émettre dans le domaine infrarouge.

Un dispositif selon l'invention peut comporter en outre deux miroirs de Bragg, la couche d'arrêt étant située au voisinage des miroirs de Bragg.

La couche d'arrêt est par exemple d'une épaisseur comprise entre 50 nm et 200 nm.

Un dispositif selon l'invention est par exemple apte à émettre au moins une longueur d'onde absorbée par le méthane ou un oxyde de carbone ou un oxyde d'azote.

### BRÈVE DESCRIPTION DES DESSINS

- La figure 1 représente un dispositif connu de l'art antérieur,
- la figure 2 représente un spectre d'émission d'un ensemble barrière/puits/barrière et un spectre de transmission d'un couple de miroirs de Bragg formant une microcavité,
- la figure 3 représente le spectre d'un dispositif connu, résultant de l'effet de microcavité (filtrage de la luminescence par les miroirs),
- la figure 4 représente un empilement selon l'invention, avec couche filtrante et couche d'arrêt confondues,
- la figure 5 représente les spectres des différents éléments d'un dispositif selon l'invention,
- la figure 6 représente le spectre résultant pour un dispositif selon l'invention.

### EXPOSÉ DÉTAILLÉ DE MODES DE RÉALISATION PARTICULIERS

Un premier exemple de réalisation de l'invention est illustré en figure 4. Les références numériques identiques à celles de la figure 1 désignent des éléments identiques ou similaires.

Dans cette structure d'un dispositif d'émission selon l'invention la couche d'arrêt est également une couche filtrante 12, par -exemple une couche en CdHgTe dont la composition est choisie pour que cette couche absorbe le rayonnement parasite. Dans le cas où la couche 10 est également en CdHgTe, cette couche 12 a une teneur en Cd supérieure à celle du puits 10. Les couches barrières 6, 8 peuvent aussi avoir des compositions de type CdHgTe, auquel cas la teneur en Cd de la couche 12 est comprise entre celle du puits 10 et celle des barrières 6, 8.

La couche 12 ne gêne donc pas l'émission à la longueur d'onde du dispositif et ne participe pas, non plus, à l'émission à cette longueur d'onde.

Cette couche 12 est insérée directement dans la structure, elle peut donc être réalisée par épitaxie en même temps que la cavité (barrières 6,8 + puits 10).

Cette couche 12 est située directement au voisinage des miroirs de Bragg 2 ou 4, qui peuvent être déposés sur cette même couche.

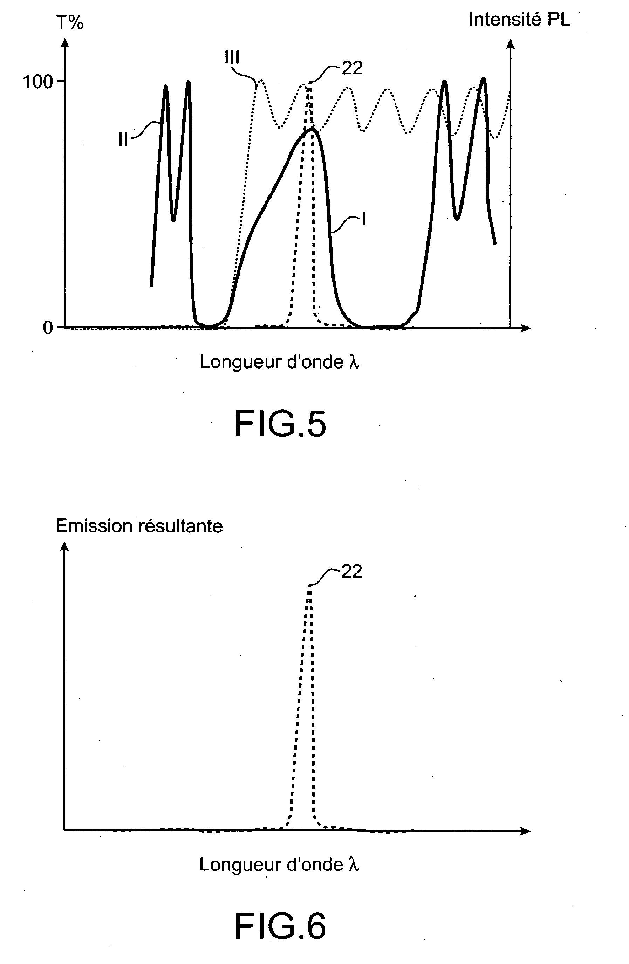

La figure 5 est équivalente à la figure 2 mais on y a ajouté le spectre III de transmission d'une couche épaisse équivalente à la couche filtre 12 et dont la composition d'alliage CdHgTe a été choisie pour absorber la partie du spectre de photoluminescence située en dessous de la coupure inférieure des miroirs, c'est-à-dire pour filtrer les longueurs d'onde inférieures à la limite inférieure de la bande de réflectivité de la cavité.

On reconnaît le spectre (courbe I) de photoluminescence, qui présente une queue 20, du coté des hautes énergies ; superposée à ce spectre est également représentée la courbe II, ou spectre de réflectivité typique d'un couple de miroirs de Bragg (résonateur Fabry-Perrot).

Le spectre d'émission résultant est, du fait de la couche filtre, purgé de l'émission parasite 26 visible en figure 3.

La couche filtre 12 peut ne pas être une couche épaisse (elle a par exemple une épaisseur comprise entre 50 nm et 200 nm). Son efficacité d'absorption pourra donc être moindre que celle présentée sur la figure 5. Cependant cet inconvénient est compensé par le fait que les photons effectuent des allers-retours multiples dans la cavité avant d'être extraits via le miroir de sortie. Au final, le spectre d'émission de l'émetteur sera efficacement débarrassé de toute émission parasite côté hautes énergies. La sélectivité spectrale de ce type de structures est donc assurée par l'ajout, dans la structure, de la couche filtre.

Selon un exemple de réalisation d'un dispositif selon l'invention, avec couche d'arrêt cumulant la fonction de filtre, l'empilement est élaboré selon un procédé comportant les étapes suivantes. Sur un substrat, on fait croître, par exemple par épitaxie :
- une couche filtre 12 qui possède aussi la fonction de couche d'arrêt,
- une couche barrière 6,
- une couche émettrice 10,
- une couche barrière 8.

On dépose ensuite un premier miroir. Par gravure jusqu'à la couche d'arrêt, on supprime le substrat. Sur la surface libérée est déposé le deuxième miroir.

La couche filtre/arrêt a une composition en cadmium supérieure à celle de la couche émettrice et inférieure à celle des couches barrière. Son épaisseur peut être faible car elle est située dans la cavité. Elle bénéficie donc des allers-retours des photons dans cette cavité.

Par exemple, pour un émetteur qui est prévu pour détecter le CH₄ (à 3,31 µm) et pour une microcavité dite « λ » (microcavité dont l'épaisseur vaut exactement λ/n, où λ est la longueur d'onde des photons (ici : 3.31 µm) et où n est l'indice du matériau), la structure d'une cavité selon l'invention est la suivante :
- substrat,
- miroir : 3 bicouches ZnS/YF₃ d'épaisseur par exemple 2700 nm,
- couche 12 filtre/arrêt : composition en cadmium 0.40 (CdₓHg₁₋ₓTe, x = 0,4), d'épaisseur 100 nm,
- couche barrière 6 : composition en cadmium 0.65 (Cd_{z}Hg_{1-z}Te, z = 0,65), épaisseur 350nm,
- couche émettrice 10: composition 0.36 en cadmium (Cd_{y}Hg_{1-y}Te, y = 0,36), d'épaisseur 200 nm,
- couche barrière 8 : composition en cadmium 0.65 (Cd_{z}Hg_{1-z}Te, z = 0,65), épaisseur 430 nm,
- miroir : 6 bicouches ZnS/YF₃ d'épaisseur par exemple 5400 nm.

La composition x en cadmium de la couche filtre/barrière peut prendre toutes les valeurs entre la composition y en Cd de la couche émettrice et celle (z) des barrières. L'épaisseur de cette couche peut varier typiquement entre 50 nm et 200nm. Les épaisseurs des autres couches, notamment celles des couches barrières, seront alors recalculées pour conserver une cavité "λ".

D'autres gaz peuvent aussi être détectés en adaptant la composition du matériau, par exemple les oxydes de carbone (CO, et/ou CO₂) et/ou les oxydes d'azote (NO) .

Par ailleurs, d'autres matériaux peuvent être utilisés comme par exemple les composés GaInAsSb avec toutes les compositions possibles comme les ternaires GaAsSb et InAsSb.

## Revendications

1. Dispositif d'émission de lumière comportant, entre un miroir d'entrée (2) et un miroir de sortie (4) formant une cavité, celle-ci présentant une bande de réflectivité, un empilement comportant lui-même une couche d'arrêt de gravure (12) et une couche active (10) **caractérisé en ce que** la couche d'arrêt est apte à filtrer au moins les longueurs d'onde inférieures à la limite inférieure de la bande de réflectivité, la couche active (10) étant en CdₓHg₁₋ₓ Te, et la couche d'arrêt de gravure (12) en Cd_{y}Hg_{1-y}Te, avec x < y.

2. Dispositif selon l'une des revendications 1, la couche active (10) étant en un matériau apte à émettre dans le domaine infrarouge.

3. Dispositif selon l'une des revendications 1 ou 2, la couche d'arrêt de gravure (12) étant en Cd_{y}Hg_{1-y}Te, la cavité comportant en outre deux couches barrières (6, 8) de composition Cd_{z}Hg_{1-z}Te, avec y < z.

4. Dispositif selon l'une des revendications 1 à 3, les miroirs d'entrée et de sortie étant deux miroirs de Bragg (2, 4), la couche d'arrêt de gravure étant située au voisinage des miroirs de Bragg.

5. Dispositif selon l'une des revendications 1 à 4, la couche d'arrêt de gravure (12) ayant une épaisseur comprise entre 50 nm et 200 nm.

6. Dispositif selon l'une des revendications précédentes, apte à émettre au moins une longueur d'onde absorbée par le méthane ou un oxyde de carbone ou un oxyde d'azote.

## Claims

1. Light emitting device comprising, between an input mirror (2) and an output mirror (4) forming a cavity, the latter having a reflectivity strip, a stack itself comprising an etch stop layer (12) and an active layer (10), **characterized in that** said stop layer being adapted to filter at least the wavelengths lower than the lower limit of the reflectivity strip, the active layer (10) being in CdₓHg₁₋ₓTe, and the etch stop layer (12) in Cd_{y}Hg_{1-y}Te, where x < y.

2. Device according to claim 1, the active layer (10) being in a material adapted to emit in the infrared domain.

3. Device according to one of claims 1 or 2, the etch stop layer (12) being in Cd_{y}Hg_{1-y}Te, the cavity further comprising two barrier layers (6, 8) of composition Cd_{z}Hg_{1-z}Te, where y < z.

4. Device according to one of claims 1 to 3, the input and output mirrors being two Bragg mirrors (2, 4), the etch stop layer being situated in the neighbourhood of the Bragg mirrors.

5. Device according to one of claims 1 to 4, the etch stop layer (12) having a thickness of between 50 nm and 200 nm.

6. Device according to one of the previous claims, adapted to emitting at least one wavelength absorbed by methane or an oxide of carbon or an oxide of nitrogen.

## Patentansprüche

1. Licht emittierende Anordnung, die zwischen einem Eingangsspiegel (2) und einem Ausgangsspiegel (4), die einen Resonator mit einem Reflektivitätsband bilden, einen Stapel umfasst, der eine Ätzsperrschicht (12) und eine aktive Schicht (10) enthält,
**dadurch gekennzeichnet, dass** die Sperrschicht fähig ist, wenigstens die Wellenlängen zu filtern, die niedriger sind als die untere Grenze des Reflektivitätsbands, wobei die aktive Schicht (10) aus CdₓHg₁₋ₓTe und die Ätzsperrschicht (12) aus Cd_{y}Hg_{1-y}Te ist, mit x < y.

2. Anordnung nach Anspruch 1, wobei die aktive Schicht (10) aus einem zur Emission im Infirarotbereich fähigen Material ist.

3. Anordnung nach einem der Ansprüche 1 oder 2, wobei die Ätzsperrschicht (12) aus Cd_{y}Mg_{1-y}Te ist und der Resonator außerdem zwei Barriereschichten (6, 8) der Zusammensetzung Cd_{z}Hg_{1-z}Te umfasst, mit y < z.

4. Anordnung nach einem der Ansprüche 1 bis 3, wobei der Einganges- und der Ausgangsspiegel zwei Bragg-Spiegel (2, 4) sind und die Ätzsperrschicht sich in der Nähe der Bragg-Spiegel befindet.

5. Anordnung nach einem der Ansprüche 1 bis 4, wobei die Ätzsperrschicht (12) eine zwischen 50 nm und 200 nm enthaltene Dicke hat.

6. Anordnung nach einem der vorangehenden Ansprüche, fähig zur Emission wenigstens einer durch Methan oder ein Kohlenmonoxid oder ein Stickstoffoxid absorbierten Wellenlänge.
